# EUROPEAN PATENT APPLICATION

(11) **EP 2 455 960 A1**
(43) Date of publication of application: **23.05.2012**
(21) Application number: 09847222.8
(22) Date of filing: 15.07.2009
(51) Int. Cl.: H01H 47/32, H03K 17/72

(54) **SWITCHING CIRCUIT WITH INDEPENDENT DC POWER SUPPLY UNIT**

(71) Applicant: Huo, Weimin, Guangdong 518038 (CN)
(72) Inventor: SUI, Haiyan, Guangdong 518038 (CN)
(74) Representative: Van Straaten, Joop
(86) International application number: PCT/CN2009/072779
(87) International publication number: WO 2011/006297

(57) **Abstract**

A switch circuit with independent direct current (DC) power supply is provided. The switch circuit includes a switch unit, a power supply unit of the switch unit, an on/off unit of the power supply unit, and/or an on/off unit of the power supply unit, and an on/off control signal transmission unit. Through the switch circuit with independent DC power supply, the problem of a waste of power consumption due to redundant power supply generated by a power supply unit when a switch unit is turned off in a conventional switch circuit sharing a DC power supply source with a control unit is effectively solved. In the provided switch circuit, the control unit and the switch unit respectively have independent power supply units, the power supply unit of the switch unit is turned on only when the switch unit needs to be turned on, and the power supply unit is turned off when the switch unit is turned off.

## Description

### BACKGROUND OF THE INVENTION

### Field of Invention

The present invention relates to an electronic switch circuit, and more particularly, to a switch circuit with independent direct current (DC) power supply.

### Related Art

Generally, a switch unit and a control unit of an electronic switch circuit share a power supply unit. However, power consumption of the control unit is low, generally from tens of microamperes to milliamps, while the switch unit has higher power consumption than the control unit. For example, a driving current of a relay or controlled silicon is about tens of milliamps, and the power consumption of the switch unit may be over ten times higher than the control unit. In this way, in order to meet the requirements of the switch unit for power supply when the switch unit is turned on, the power supply unit needs to maintain a redundant power supply capability much greater than that required by the control unit. When the power supply unit adopts a capacitor voltage dropping DC power source, the input current is approximately constant, so when the switch unit is turned off, the redundant current is consumed on a voltage stabilizer, thereby resulting in a waste of the power consumption.

### SUMMARY OF THE INVENTION

The present invention is directed to solve the above problems, and provides a switch circuit, where a switch unit has an independent power supply unit different from a power supply unit of a control unit, the power supply unit of the switch unit may be turned on or turn off under the control of the control unit, so that the power supply unit of the switch unit is turned on for power supply only when the switch unit needs to be turned on. This switch circuit effectively solves the problem of a waste of power consumption generated when a switch unit is turned off in a conventional switch circuit sharing a DC power source with a control unit.

A difference between the switch circuit of the present invention and a driving circuit of an Alternating Current (AC) contactor should be illustrated here. The AC contactor is directly driven by an AC current of an external power source, and the AC contactor can be turned on as long as a control unit turns on an AC loop of the external power source and the AC contactor can be turned off as long as the control unit turns off the AC loop of the external power source. The switch circuit of the present invention is applicable to a switch circuit adopting a DC power supply source, and a switch device thereof adopts a relay driven by a low-voltage DC, so the switch circuit of the present invention is different from the driving circuit of the AC contactor directly driven by the AC current of the external power source.

In addition to the driving circuit of the AC contactor, in some switch circuits applied to industrial control, in order to prevent an interference signal at one side of the switch circuit from affecting the control part, power supply circuits independent from each other are respectively applied in the switch circuit and the control part. However, the power supply circuit of the switch circuit is set for anti-interference, and is not turned off when the switch circuit is turned off. The difference is that, in the switch circuit with independent DC power supply of the present invention, the power supply circuit of the switch unit is turned off when or after the switch unit is turned off to save power consumption.

In order to achieve the above objectives, a switch circuit with independent DC power supply is provided, where the switch circuit includes:
a switch unit;
a power supply unit of the switch unit, connected to the switch unit, an on/off unit of the power supply unit, and an external power source;
the on/off unit of the power supply unit, connected to the power supply unit of the switch unit and an on/off control signal transmission unit; and
the on/off control signal transmission unit, connected to the on/off unit of the power supply unit and a control unit.

A switch device of the switch unit is a DC-driven replay or controlled silicon.

The power supply unit of the switch unit is a DC power supply circuit for providing a driving current for the switch unit.

The power supply unit of the switch unit has a capacitor voltage dropping circuit, a resistor voltage dropping circuit, or a transformer voltage dropping circuit.

A rectification circuit of the power supply unit of the switch unit is a bridge diode rectification circuit or a half-bridge diode rectification circuit.

When the power supply unit of the switch unit is turned on for power supply, the switch unit is turned on; and when the power supply unit of the switch unit is turned off, the switch unit is turned off, so as to save the power consumption when the switch unit is turned off.

The on/off unit of the power supply unit is used to turn on or turn off the power supply unit of the switch unit.

A switch device used by the on/off unit of the power supply unit is a crystal switch tube, controlled silicon or a relay.

The on/off control signal transmission unit is used to transmit an on/off signal of the control unit to the on/off unit of the switch unit.

The on/off control signal transmission unit is directly and electrically connected when the power supply unit of the control unit and the power supply unit of the switch unit are commonly grounded.

The on/off control signal transmission unit is a photoelectric coupling circuit, a capacitor circuit or a mutual inductor circuit for isolating and transmitting a signal when the power supply unit of the control unit and the power supply unit of the switch unit are not commonly grounded.

In order to achieve the above objectives, a switch circuit with independent DC power supply is provided, where the switch circuit includes:
a switch unit;
a power supply unit of the switch unit, connected to the switch unit, an on/off unit of the power supply unit, and an external power source;
an on/off unit of the switch unit, connected to the switch unit and an on/off control signal transmission unit;
the on/off unit of the power supply unit, connected to the power supply unit of the switch unit and the on/off control signal transmission unit; and
the on/off control signal transmission unit, connected to the on/off unit of the power supply unit, an on/off unit of the switch unit, and a control unit.

A switch device of the switch unit is a DC-driven replay or controlled silicon.

The power supply unit of the switch unit is a DC power supply circuit for providing a driving current for the switch unit.

The power supply unit of the switch unit has a capacitor voltage dropping circuit, a resistor voltage dropping circuit, or a transformer voltage dropping circuit.

A rectification circuit of the power supply unit of the switch unit is a bridge diode rectification circuit or a half-bridge diode rectification circuit.

After the power supply unit of the switch unit is turned on, the switch unit is turned on; and after the switch unit is turned off, the power supply unit of the switch unit is turned off, so as to save the power consumption when the switch unit is turned off.

The on/off unit of the power supply unit is used to turn on or turn off the power supply unit of the switch unit.

A switch device used by the on/off unit of the power supply unit is a crystal switch tube, controlled silicon or a relay.

The on/off unit of the switch unit is used to turn on or turn off the switch unit.

A switch device used by the on/off unit of the switch unit is a crystal switch tube, controlled silicon or a relay.

The on/off control signal transmission unit is used to transmit an on/off signal of the control unit to the on/off unit of the switch unit and the on/off unit of the switch unit.

The on/off control signal transmission unit is directly and electrically connected when the power supply unit of the control unit and the power supply unit of the switch unit are commonly grounded.

The on/off control signal transmission unit is a photoelectric coupling circuit, a capacitor circuit or a mutual inductor circuit for isolating and transmitting a signal when the power supply unit of the control unit and the power supply unit of the switch unit are not commonly grounded.

The present invention effectively solves the problem of a waste of power consumption due to redundant power supply generated by the power supply unit when the switch unit is turned off in the conventional switch circuit sharing the DC power supply source with the control unit. Then, the present invention provides a switch circuit, in which the control unit and the switch unit respectively have independent power supply units, the power supply unit of the switch unit is turned on only when the switch unit needs to be turned on, and the power supply unit is turned off when the switch unit is turned off.

### BRIEF DESCRIPTION OF THE DRAWINGS

FIG. 1 is a schematic diagram of a circuit according to an embodiment of the present invention;
FIG. 2 is a schematic diagram of a circuit according to an embodiment of the present invention; and
FIG. 3 is a schematic diagram of a circuit according to an embodiment of the present invention.

### DETAILED DESCRIPTION OF THE INVENTION

A switch circuit with independent DC power supply of the present invention adopts an independent power supply unit different from a power supply unit of a control unit, and the power supply unit of the switch unit is turned on as the switch unit is turned on and is turned off as the switch unit is turned off.

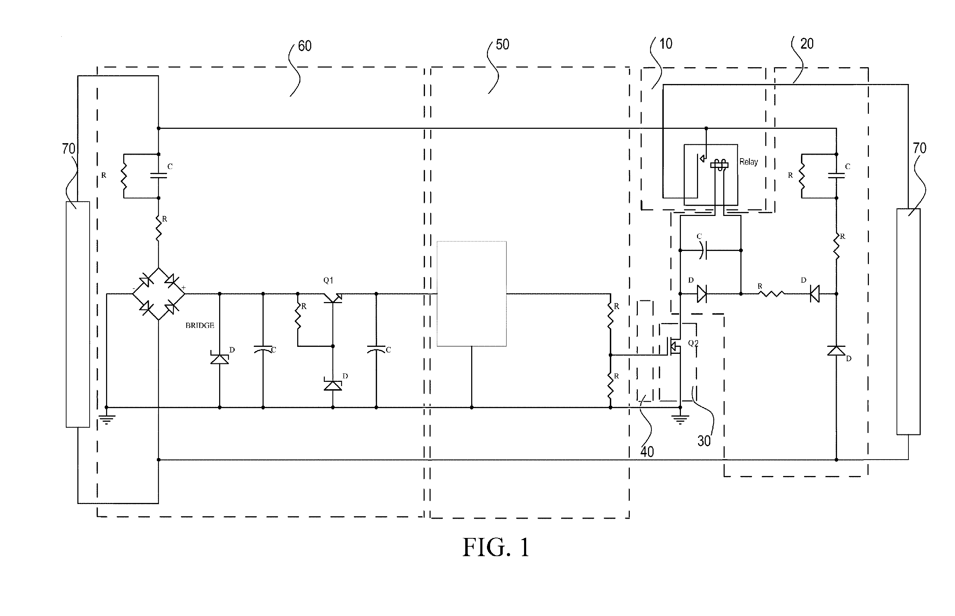

As shown in FIG. 1, in a switch circuit with independent DC power supply, a switch device used by a switch unit 10 is a DC-driven relay. In a power supply unit 20 of the switch unit, a rectification circuit is a half-bridge diode rectification circuit, and a voltage dropping circuit is a capacitor voltage dropping circuit. A switch device of an on/off unit 30 of the power supply unit of the switch unit is a voltage-driven field effect transistor (FET) Q2. A power supply unit 60 of a control unit is a bridge diode rectification circuit, and the power supply unit 60 and the power supply unit 20 of the switch unit adopting the half-bridge diode rectification circuit may be commonly grounded, so an on/off control signal transmission unit 40 may be directly and electrically connected.

As shown in FIG. 1, the control unit 50 turns on the FET Q2 of the on/off unit 30 of the power supply unit through the on/off control signal transmission unit 40, and the power supply unit 20 of the switch unit is turned on for power supply since the FET of the on/off unit 30 of the power supply unit is turned on. When the power supply unit 20 of the switch unit is turned on, a loop current thereof flows through a driving coil of the switch device, the DC-driven relay, of the switch unit 10 to form a driving current, so that the relay is closed and turned on. The control unit 50 turns on the FET Q2 of the on/off unit 30 of the power supply unit through the on/off control signal transmission unit 40, and turns off the FET Q2 of the on/off unit 30 of the power supply unit through the on/off control signal transmission unit 40, and the power supply unit 20 of the switch unit is turned off since the FET Q2 of the on/off unit 30 of the power supply unit is turned off. When the power supply unit 20 of the switch unit is turned off, the loop current thereof is turned off, and the driving current of the driving coil of the switch device, the DC-driven relay, of the switch unit 10 is also turned off, so that the relay is separated and turned off.

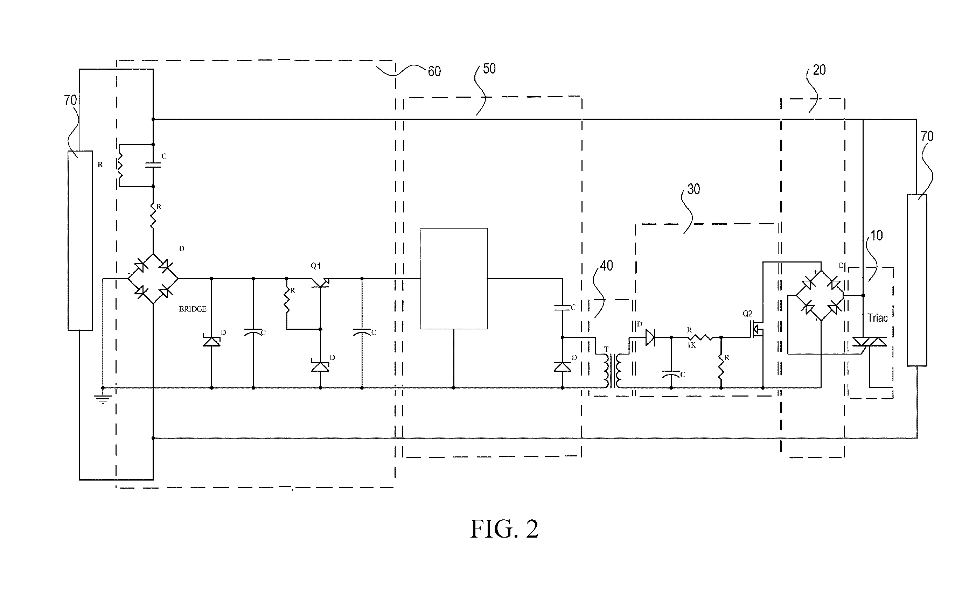

As shown in FIG. 2, in a switch circuit with independent DC power supply, a switch device used by the switch unit 10 is bi-directional controlled silicon Triac. A rectification circuit used by the power supply unit 20 of the switch unit is a bridge diode rectification circuit. A switch device of an on/off unit 30 of the power supply unit of the switch unit adopts a voltage-driven EFT Q2. A power supply unit 60 of a control unit also adopts a bridge diode rectification circuit, and the power supply unit 60 and the power supply unit 20 of the switch unit adopting the bridge diode rectification circuit cannot be commonly grounded, so an on/off control signal transmission unit 40 adopts a mutual inductor circuit for isolating and transmitting a signal.

As shown in FIG. 2, when the switch circuit needs to be turned on, the control unit 50 sends a pulse turn-on signal to the on/off control signal transmission unit 40. The pulse signal is transmitted to the on/off unit 30 of the power supply unit through a mutual inductor T of the on/off control signal transmission unit 40 and forms a turn-on driving voltage of the switch device FET Q2 of the on/off unit 30 of the power supply unit through a rectification filter circuit of the on/off unit 30 of the power supply unit, to turn on the switch device FET Q2 of the on/off unit 30 of the power supply unit. The switch device FET Q2 of the on/off unit 30 of the power supply unit connected to a DC end of the bridge diode rectification circuit of the power supply unit 20 of the switch unit is turned on, so that an AC end of the bridge diode rectification circuit of the power supply unit 20 of the switch unit is turned on. The AC end of the bridge diode rectification circuit of the power supply unit 20 of the switch unit is turned on, so that a driving loop of the bi-directional controlled silicon Triac of the switch unit 10 is turned on, and an output of the Triac switch is turned on.

As shown in FIG. 2, when the switch circuit needs to be turned off, the control unit 50 stops sending a pulse turn-on signal to the on/off control signal transmission unit 40, and the pulse signal transmitted to the on/off unit 30 of the power supply unit through the mutual inductor T of the on/off control signal transmission unit 40 is also stopped. In this case, the turn-on driving voltage of the switch device FET Q2 of the on/off unit 30 of the power supply unit formed through the rectification filter circuit of the on/off unit 30 disappears, the switch device FET Q2 of the on/off unit 30 of the power supply unit is turned off, and the bridge diode rectification circuit of the power supply unit 20 of the switch unit is also turned off. Therefore, the driving loop of the bi-directional controlled silicon Triac of the switch unit 10 is disconnected, and the output of the Triac switch is turned off. Therefore, the power supply unit 20 and the switch unit 10 are turned off at the same time.

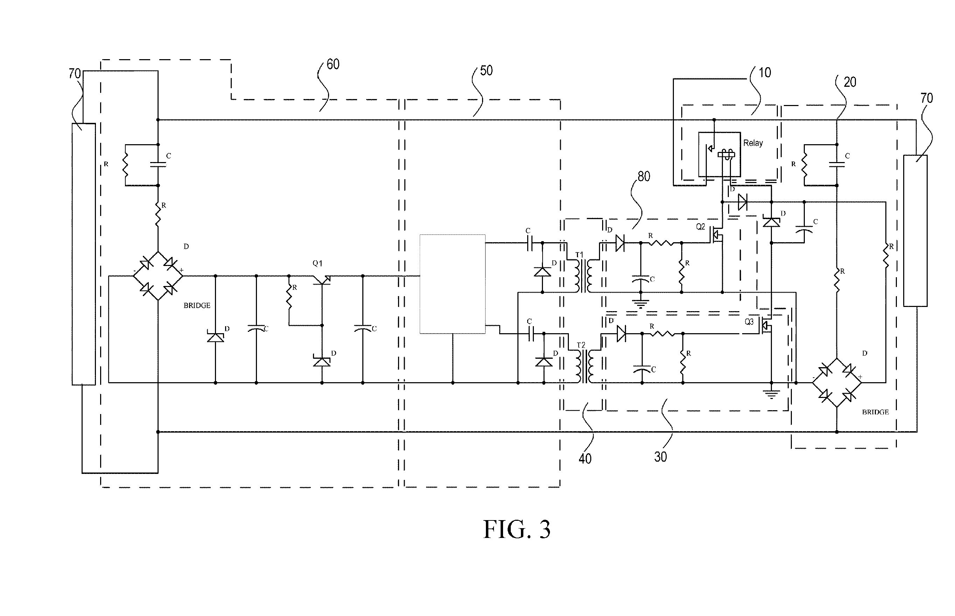

As shown in FIG. 3, in a switch circuit with independent DC power supply, a switch device used by the switch unit 10 is a DC-driven relay. In a power supply unit 20 of the switch unit, a rectification circuit is a bridge diode rectification circuit, and a voltage dropping circuit is a capacitor voltage dropping circuit. A switch device of an on/off unit 30 of the power supply unit adopts a voltage-driven EFT Q2. A switch device of an on/off unit 80 of the switch unit adopts a voltage-driven EFT Q3. A power supply unit 60 of a control unit also adopts a bridge diode rectification circuit, and the power supply unit 60 and the power supply unit 20 of the switch unit adopting the bridge diode rectification circuit cannot be commonly grounded, so an on/off control signal transmission unit 40 adopts two mutual inductor circuits for isolating and transmitting a signal, and connected to the on/off unit 30 of the power supply unit and the on/off unit 80 of the switch unit respectively.

As shown in FIG. 3, when the switch circuit needs to be turned on, the control unit 50 first sends a pulse turn-on signal to a mutual inductor T2 of the on/off control signal transmission unit 40 connected to the on/off unit 30 of the power supply unit. The pulse signal is transmitted to the on/off unit 30 of the power supply unit through the mutual inductor T2 of the on/off control signal transmission unit 40 and forms a turn-on driving voltage of a switch device FET Q3 of the on/off unit 30 of the power supply unit through a rectification filter circuit of the on/off unit 30 of the power supply unit to turn on the switch device FET Q3 of the on/off unit 30 of the power supply unit. The switch device FET Q3 of the on/off unit 30 of the power supply unit connected to the power supply unit 20 of the switch unit is turned on, so that the power supply unit 20 of the switch unit is turned on to provide a driving current for the switch device Relay of the switch unit 10.

As shown in FIG. 3, after the power supply unit 20 of the switch unit is turned on, the control unit 50 sends a pulse turn-on signal to a mutual inductor T1 of the on/off control signal transmission unit 40 connected to the on/off unit 80 of the switch unit. The pulse signal is transmitted to the on/off unit 80 of the switch unit through the mutual inductor T1 of the on/off control signal transmission unit 40 and forms a turn-on driving voltage of a switch device FET Q2 of the on/off unit 80 of the switch unit through a rectification filter circuit of the on/off unit 80 of the switch unit to turn on the switch device FET Q2 of the on/off unit 80 of the switch unit. When the switch device FET Q2 of the on/off unit 80 of the switch unit connected to the switch unit 10 is turned on, a loop current thereof flows through a driving coil of the switch device, the DC-driven relay, of the switch unit 10 to form a driving current, so that the relay is closed and turned on.

As shown in FIG. 3, when the switch circuit needs to be turned off, the control unit 50 first stops sending a pulse turn-on signal to the mutual inductor T1 of the on/off control signal transmission unit 40 connected to the on/off unit 80 of the switch unit. The pulse signal transmitted to the on/off unit 80 of the switch unit through the mutual inductor T1 of the on/off control signal transmission unit 40 is also turned off. In this case, the switch device FET Q2 of the on/off unit 80 of the switch unit is turned off, the driving current of the switch device, the DC-driven relay, of the switch unit 10 is turned off, and an output of the switch device, the DC-driven relay, of the switch unit 10 is also turned off.

As shown in FIG. 3, after the output of the switch device, the DC-driven relay, of the switch unit 10 is turned off, the control unit 50 stops sending the pulse turn-on signal to the mutual inductor T2 of the on/off control signal transmission unit 40 connected to the on/off unit 30 of the power supply unit, and the pulse signal transmitted to the on/off unit 30 of the power supply unit through the mutual inductor T2 of the on/off control signal transmission unit 40 is stopped. Therefore, the switch device FET Q3 of the on/off unit 30 of the power supply unit is turned off. The switch device FET Q3 of the on/off unit 30 of the power supply unit connected to the power supply unit 20 of the switch unit is turned off, so that the power supply unit 20 of the switch unit is turned off. Therefore, the power supply unit 20 of the switch unit is also turned off as the switch unit 10 is turned off, so as to save the power consumption.

The devices used by the above units may all be common devices.

The present invention has been disclosed through the foregoing embodiments, but the scope of the present invention is not limited thereto. The components of the present invention can be replaced with similar or the same elements known by persons skilled in the art without departing from the idea of the present invention.

## Claims

1. A switch circuit with an independent direct current (DC) power supply loop, comprising:
a switch unit (10);
a power supply unit (20) of the switch unit, connected to the switch unit (10), an on/off unit (30) of the power supply unit, and an external power source (70);
the on/off unit (30) of the power supply unit, connected to the power supply unit (20) of the switch unit and an on/off control signal transmission unit (40); and
the on/off control signal transmission unit (40), connected to the on/off unit (30) of the power supply unit and a control unit (50).

2. The switch circuit with an independent DC power supply loop according to claim 1, wherein a switch device of the switch unit (10) is a DC-driven relay or controlled silicon.

3. The switch circuit with an independent DC power supply loop according to claim 1, wherein the power supply unit (20) of the switch unit is a DC power supply circuit for providing a driving current for the switch unit (10).

4. The switch circuit with an independent DC power supply loop according to claim 1, wherein the power supply unit (20) of the switch unit comprises a capacitor voltage dropping circuit, or a resistor voltage dropping circuit, or a transformer voltage dropping circuit.

5. The switch circuit with an independent DC power supply loop according to claim 1, wherein a rectification circuit of the power supply unit (20) of the switch unit is a bridge diode rectification circuit or a half-bridge diode rectification circuit.

6. The switch circuit with an independent DC power supply loop according to claim 1, wherein when the power supply unit (20) of the switch unit is turned on for power supply, the switch unit (10) is turned on; and when the power supply unit (20) of the switch unit is turned off, the switch unit (20) is turned off, so as to save power consumption when the switch unit (10) is turned off.

7. The switch circuit with an independent DC power supply loop according to claim 1, wherein the on/off unit (30) of the power supply unit is used to turn on or turn off the power supply unit (20) of the switch unit.

8. The switch circuit with an independent DC power supply loop according to claim 1, wherein a switch device used by the on/off unit (30) of the power supply unit is a crystal switch tube, controlled silicon, or a relay.

9. The switch circuit with an independent DC power supply loop according to claim 1, wherein the on/off control signal transmission unit (40) is used to transmit an on/off signal of the control unit (50) to the on/off unit (30) of the switch unit.

10. The switch circuit with an independent DC power supply loop according to claim 1, wherein the on/off control signal transmission unit (40) is directly and electrically connected when the power supply unit (60) of the control unit and the power supply unit (20) of the switch unit are commonly grounded.

11. The switch circuit with an independent DC power supply loop according to claim 1, wherein the on/off control signal transmission unit (40) is a photoelectric coupling circuit, a capacitor circuit or a mutual inductor circuit for isolating and transmitting a signal when the power supply unit (60) of the control unit and the power supply unit (20) of the switch unit are not commonly grounded.

12. A switch circuit with an independent direct current (DC) power supply loop, comprising:
a switch unit (10);
a power supply unit (20) of the switch unit, connected to the switch unit (10), an on/off unit (30) of the power supply unit, and an external power source (70);
an on/off unit (80) of the switch unit, connected to the switch unit (10) and an on/off control signal transmission unit (40);
an on/off unit (30) of the power supply unit, connected to the power supply unit (20) of the switch unit and the on/off control signal transmission unit (40); and
the on/off control signal transmission unit (40), connected to the on/off unit (30) of the power supply unit, an on/off unit (80) of the switch unit, and a control unit (50).

13. The switch circuit with an independent DC power supply loop according to claim 12, wherein a switch device of the switch unit (10) is a DC-driven relay or controlled silicon.

14. The switch circuit with an independent DC power supply loop according to claim 12, wherein the power supply unit (20) of the switch unit is a DC power supply circuit for providing a driving current for the switch unit (10).

15. The switch circuit with an independent DC power supply loop according to claim 12, wherein the power supply unit (20) of the switch unit comprises a capacitor voltage dropping circuit, or a resistor voltage dropping circuit, or a transformer voltage dropping circuit.

16. The switch circuit with an independent DC power supply loop according to claim 12, wherein a rectification circuit of the power supply unit (20) of the switch unit is a bridge diode rectification circuit or a half-bridge diode rectification circuit.

17. The switch circuit with an independent DC power supply loop according to claim 12, wherein when the power supply unit (20) of the switch unit is turned on for power supply, the switch unit (10) is turned on; and after the switch unit (10) is turned off, the power supply unit (20) of the switch unit is turned off, so as to save power consumption when the switch unit (10) is turned off.

18. The switch circuit with an independent DC power supply loop according to claim 12, wherein the on/off unit (30) of the power supply unit is used to turn on or turn off the power supply unit (20) of the switch unit.

19. The switch circuit with an independent DC power supply loop according to claim 12, wherein a switch device used by the on/off unit (30) of the power supply unit is a crystal switch tube, controlled silicon or a relay.

20. The switch circuit with an independent DC power supply loop according to claim 12, wherein the on/off unit (80) of the switch unit is used to turn on or turn off the switch unit (10).

21. The switch circuit with an independent DC power supply loop according to claim 12, wherein a switch device used by the on/off unit (80) of the switch unit is a crystal switch tube, controlled silicon or a relay.

22. The switch circuit with an independent DC power supply loop according to claim 12, wherein the on/off control signal transmission unit (40) is used to transmit an on/off signal of the control unit (50) to the on/off unit (30) of the switch unit and the on/off unit (80) of the switch unit.

23. The switch circuit with an independent DC power supply loop according to claim 12, wherein the on/off control signal transmission unit (40) is directly and electrically connected when the power supply unit (60) of the control unit and the power supply unit (20) of the switch unit are commonly grounded.

24. The switch circuit with an independent DC power supply loop according to claim 12, wherein the on/off control signal transmission unit (40) is a photoelectric coupling circuit, a capacitor circuit or a mutual inductor circuit for isolating and transmitting a signal when the power supply unit (60) of the control unit and the power supply unit (20) of the switch unit are not commonly grounded.
